# EUROPEAN PATENT APPLICATION

(11) **EP 3 972 000 A1**
(43) Date of publication of application: **23.03.2022**
(21) Application number: 20841144.7
(22) Date of filing: 08.07.2020
(51) Int. Cl.: H01L 41/187, H01L 41/318, H01L 41/43

(54) **PIEZOELECTRIC FILM AND PIEZOELECTRIC ELEMENT**

(30) Priority: 12.07.2019 JP 2019130521
(71) Applicant: Mitsubishi Materials Corporation, Tokyo 100-8117 (JP)
(72) Inventor: TSUJIUCHI Naoto, Naka-shi, Ibaraki 311-0102 (JP); SOYAMA Nobuyuki, Naka-shi, Ibaraki 311-0102 (JP)
(74) Representative: Gille Hrabal Partnerschaftsgesellschaft mbB Patentanwälte
(86) International application number: PCT/JP2020/026652
(87) International publication number: WO 2021/010244

(57) **Abstract**

A piezoelectric film contains iron-containing potassium sodium niobate represented by General Formula (1) and granular crystal particles having an average aspect ratio of 3 or less.

(KₓNa₁₋ₓ)ₐ(Fe_{y}Nb_{z})O₃ ... (1)

In Formula (1), x represents a number satisfying 0 < x < 1, a represents a number satisfying 0.90 < a ≤ 1, and y and z represent numbers satisfying y + z = 1 and 0.006 ≤ y/z ≤ 0.04.

## Description

### TECHNICAL FIELD

The present invention relates to a piezoelectric film and a piezoelectric element.

Priority is claimed on Japanese Patent Application No. 2019-130521 filed July 12, 2019, the content of which is incorporated herein by reference.

### BACKGROUND ART

Piezoelectric elements having a piezoelectric film and electrodes arranged on the upper and lower surfaces of the piezoelectric film are used in various piezoelectric devices, such as vibration-generating elements, sensors, actuators, ink jet heads, and autofocusing devices. As a piezoelectric film, KNN-based piezoelectric films formed of potassium sodium niobate (KNaNbO₃) are known. KNN-based piezoelectric films are attracting attention as lead-free piezoelectric films.

Chemical solution deposition methods (CSD: also known as chemical solution volume methods or sol-gel methods) and sputtering methods are known as methods for depositing a KNN-based piezoelectric film. In the CSD method, a precursor solution (or sol-gel solution) including the metal elements of the target composition is coated on the surface of a substrate and the piezoelectric film is deposited by firing the obtained coated film. In the sputtering method, the piezoelectric film is deposited, for example, by causing ionized argon or the like to collide with an oxide target in a high vacuum and vapor-depositing the elements ejected thereby onto a substrate. Compared to the sputtering method, the CSD method is advantageous in that a high vacuum is not necessary and it is possible to manufacture piezoelectric films using comparatively small equipment.

KNN-based piezoelectric films deposited using methods such as the CSD method and sputtering methods may have alkali metal lattice defects due to the scattering of alkali metal components during deposition. A piezoelectric element using the KNN-based piezoelectric film with lattice defects has a problem in that the electromechanical conversion efficiency is easily decreased due to the generation of leakage current when voltage is applied. In order to suppress the generation of leakage current in KNN-based piezoelectric films, research is being carried out on replacing a part of Nb with other elements. For example, Patent Document 1 describes, in relation to a KNN-based piezoelectric film with a columnar structure formed by the sputtering method, a composition in which, with respect to 100 moles of KNN, it is possible to replace the Nb and which includes, in a ratio of 3.3 moles or less, elements having an oxidation number so as to be divalent or higher and less than pentavalent when oxidized.

### Citation List

### Patent Document

[Patent Document 1] PCT International Publication No. WO2015/033791

### SUMMARY OF INVENTION

### Technical Problem

Along with a demand for the miniaturization of and increased power saving in electronic devices in recent years, there is also a desire for the miniaturization of and increased power saving in piezoelectric elements. In order to realize the miniaturization of and increased power saving in piezoelectric elements, piezoelectric films which are thin and in which leakage current is not easily generated are necessary. However, in KNN-based piezoelectric films in the related art, the crystal particles which form the piezoelectric film are columnar or have a rectangular shape which is nearly columnar and there are few points of contact between the crystal particles, thus, there is a problem in that it is difficult to suppress the generation of leakage current when the film thickness is reduced.

The present invention was created in consideration of the circumstances described above and has an object of providing a KNN-based piezoelectric film and a piezoelectric element with high electromechanical conversion efficiency and in which leakage current is not easily generated even when the film thickness is reduced.

### Solution to Problem

In order to solve the problem described above, a piezoelectric film according to an aspect of the present invention includes iron-containing potassium sodium niobate represented by General Formula (1) and granular crystal particles having an average aspect ratio of 3 or less.

(KₓNa₁₋ₓ)ₐ(Fe_{y}Nb_{z})O₃ ... (1)

In Formula (1), x represents a number satisfying 0 < x < 1, a represents a number satisfying 0.90 < a ≤ 1, and y and z represent numbers satisfying y + z = 1 and 0.006 ≤ y/z ≤ 0.04.

According to the piezoelectric film with this configuration, in the iron-containing potassium sodium niobate represented by General Formula (1), y and z satisfy y + z = 1 and 0.006 ≤ y/z ≤ 0.04, thus, in a case where an electronic defect is generated from a lattice defect of an alkali metal, the iron offsets the electronic defect. In addition, the crystal particles forming the piezoelectric film are granular crystal particles with an average aspect ratio of 3 or less, thus, the contact area between the crystal particles is large and the electron conductivity between the crystal particles is improved. For this reason, it is possible to suppress the generation of leakage current in the piezoelectric film even when the film thickness is reduced.

Here, in a piezoelectric film according to another aspect of the present invention, the granular crystal particles preferably have an average particle diameter in a range of 10 nm or more and 300 nm or less.

In this case, the contact area between the granular crystal particles is increased and the electron conductivity between the granular crystal particles is reliably improved. For this reason, it is possible to more reliably suppress the generation of leakage current in the piezoelectric film even when the film thickness is reduced.

A piezoelectric element according to still another aspect of the present invention includes a piezoelectric layer, and an electrode layer arranged on a surface of the piezoelectric layer, in which the piezoelectric layer includes the piezoelectric film according to an aspect of the present invention described above.

According to the piezoelectric element with this configuration, since the piezoelectric layer includes the piezoelectric film according to an aspect of the present invention described above, it is possible to suppress the generation of leakage current in the piezoelectric film even when the thickness is reduced.

### Advantageous Effects of Invention

According to an aspect of the present invention, it is possible to provide a KNN-based piezoelectric film and a piezoelectric element in which leakage current is not easily generated even when the film thickness is reduced.

### BRIEF DESCRIPTION OF DRAWINGS

Fig. 1 is a schematic cross-sectional view of a piezoelectric element using a piezoelectric film according to an embodiment of the present invention.
Fig. 2 is a conceptual diagram illustrating a method for measuring the long diameter and short diameter of a granular crystal particle.
Fig. 3 is a flow diagram of a method for manufacturing a piezoelectric film according to an embodiment of the present invention.
Fig. 4 is a SEM photograph of the cross-section of the piezoelectric film obtained in Example 1 of the present invention.

### DESCRIPTION OF EMBODIMENTS

A description will be given below of the piezoelectric film and piezoelectric element according to an embodiment of the present invention with reference to the accompanying drawings.

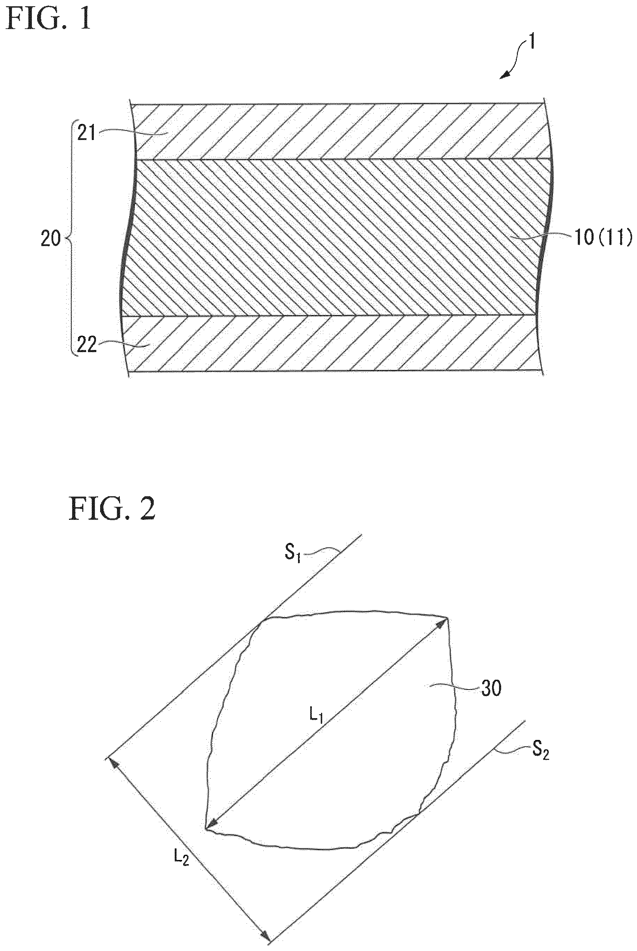

Fig. 1 is a schematic cross-sectional view of a piezoelectric element using a piezoelectric film according to an embodiment of the present invention.

As shown in Fig. 1, a piezoelectric element 1 is provided with a piezoelectric layer 11 formed of a piezoelectric film 10 and an electrode layer 20 arranged on the surface of the piezoelectric layer 11.

The piezoelectric film 10 is formed of granular crystal particles containing iron-containing potassium sodium niobate. The granular crystal particles have a perovskite crystal structure. The iron in the iron-containing potassium sodium niobate functions to offset electronic defects when electronic defects are caused by lattice defects in alkali metals. In addition, when the piezoelectric film is deposited by the CSD method, the iron suppresses the crystal particles from growing into a columnar or nearly columnar rectangular shape and acts to make the crystal particles into granular crystal particles with a low aspect ratio.

Iron-containing potassium sodium niobate is represented by General Formula (1).

(KₓNa₁₋ₓ)ₐ(Fe_{y}Nb_{z})O₃ ... (1)

In Formula (1), x represents a number satisfying 0 < x < 1. X is preferably a number satisfying 0.3 < x < 0.7, and particularly preferably a number satisfying 0.4 < x < 0.6.

a represents a number satisfying 0.90 < a ≤ 1. A case where a is less than 1 means that the alkali metal has a lattice defect. When a is 0.90 or less, there is a concern that the lattice defects of the alkali metal may be excessively numerous such that it may be difficult to maintain the perovskite crystal structure. a is preferably a number satisfying 0.95 < a ≤ 1.00, and a is particularly preferably a number satisfying 0.98 < a ≤ 1.00.

y and z represent a number satisfying y + z = 1 and 0.006 ≤ y/z ≤ 0.04. That is, iron-containing potassium sodium niobate contains iron in a range of 0.006 moles or more and 0.04 moles or less with respect to 1 mole of niobium. When the iron content is excessively low, there is a concern that it may be difficult to obtain the effects of iron addition and it may be difficult to suppress the generation of leakage current in the piezoelectric film 10. On the other hand, when the iron content is excessively high, there is a concern that it may be difficult to suppress the generation of leakage current in the piezoelectric film 10 due to the excessive presence of iron at the grain boundaries, y and z are preferably numbers satisfying 0.01 ≤ y/z ≤ 0.03, and particularly preferably numbers satisfying 0.015 ≤ y/z ≤ 0.025.

The granular crystal particles have an average aspect ratio of 3 or less. The average aspect ratio is the average of the aspect ratios of 200 arbitrarily selected granular crystal particles. The aspect ratio is the ratio (long diameter/short diameter) between the long diameter (maximum length) and short diameter (maximum long hanging diameter) of the granular crystal particles. The long diameter and short diameter of the granular crystal particles are measured using a magnified image of the granular crystal particles. The long diameter of a granular crystal particle is a maximum distance L₁ between two points on the projected contour of a granular crystal particle 30, as shown in Fig. 2. The short diameter of the granular crystal particle is a distance L₂ when the granular crystal particle 30 is interposed between two straight lines S₁ and S₂ that are parallel to the long diameter.

The average aspect ratio of the granular crystal particles being 3 or less increases the contact area between the crystal particles and improves the electron conductivity between the crystal particles. For this reason, it is possible to suppress the generation of leakage current in the piezoelectric film even when the film thickness is reduced. The average aspect ratio of the granular crystal particles is more preferably 2.5 or less, and particularly preferably 2 or less.

The granular crystal particles preferably have an average particle diameter in a range of 10 nm or more and 300 nm or less. When the average particle diameter of the granular crystal particles is in this range, the contact area between the granular crystal particles is reliably increased and the electron conductivity between the granular crystal particles is further improved, thus, it is possible to further suppress the generation of leakage current. The granular crystal particles more preferably have an average particle diameter in a range of 30 nm or more and 70 nm or less, and in a range of 40 nm or more and 70 nm or less is preferable. The average particle diameter is the average of the long diameter (maximum length) of 200 arbitrarily selected granular crystal particles.

The film thickness of the piezoelectric film 10 (piezoelectric layer 11) is not particularly limited and appropriate adjustment is possible according to the intended use. The film thickness of the piezoelectric film 10 is generally in a range of 0.5 µm or more and 5 µm or less.

The electrode layer 20 formed on the surface of the piezoelectric film 10 includes an upper electrode 21 formed on the upper surface of the piezoelectric film 10 and a lower electrode 22 formed on the lower surface of the piezoelectric film 10. It is possible to use metals such as platinum (Pt) and iridium (Ir) as materials for the upper electrode 21 and the lower electrode 22. The upper electrode 21 and the lower electrode 22 may be formed of the same material or may be formed of different materials.

Next, a description will be given of the method for manufacturing the piezoelectric film 10.

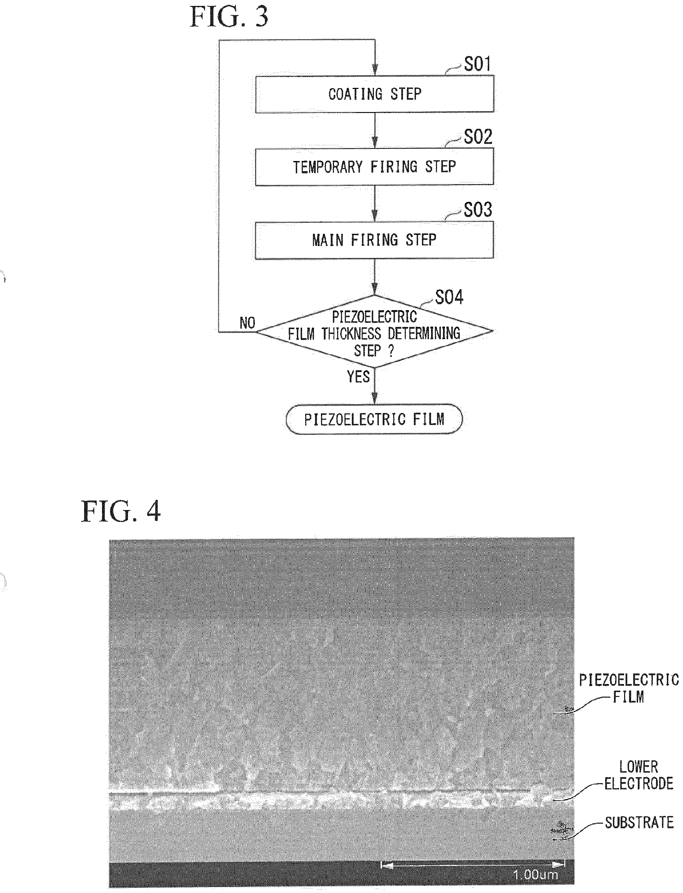

Fig. 3 is a flow diagram of a method for manufacturing a piezoelectric film according to an embodiment of the present invention.

The method for manufacturing a piezoelectric film shown in Fig. 3 includes a coating step S01, a temporary firing step S02, a main firing step S03, and a piezoelectric film thickness determining step S04.

### (Coating Step S01)

The coating step S01 is a step of coating a coating solution for forming a piezoelectric film on a substrate to obtain a coated film.

As the substrate, it is possible to use a heat-resistant substrate with a lower electrode formed on the surface thereof. As the heat-resistant substrate, it is possible to use a silicon substrate, stainless steel substrate, alumina substrate, and the like. In a case where a silicon substrate is used, a thermal oxide film (SiOx film) may be formed on the surface of the silicon substrate by thermally oxidizing the surface of the silicon substrate. The heat-resistant substrate may further have an adhesion layer to improve the adhesion with the lower electrode. As the adhesion layer, it is possible to use an aluminum oxide film (Al₂O₃ film), a titanium film, a titanium oxide film (TiOx film, 0 < x < 2), and a laminated film thereof. It is possible to deposit aluminum oxide films and titanium films by, for example, sputtering methods and CSD methods. On the other hand, it is possible to deposit the titanium oxide film by holding and firing a titanium film in an atmospheric atmosphere at a temperature of 700°C or higher and 800°C or lower for 1 to 3 minutes.

In a case where Pt is used as the material for the lower electrode, the Pt lower electrode is preferably (111) oriented. It is possible to form the (111) oriented Pt lower electrode by the sputtering method. In addition, in order to improve the adhesion between the lower electrode and the piezoelectric film, a base layer may be provided on the surface of the lower electrode. It is possible to use a lanthanum nickel oxide film as the base layer. It is possible to deposit the lanthanum nickel oxide film, for example, by a method in which a sol-gel solution, which generates a lanthanum nickel oxide film upon being heated, is coated on the surface of the lower electrode and heated (CSD method).

The coating solution for forming the piezoelectric film includes potassium, sodium, iron, and niobium in a ratio which generates iron-containing potassium sodium niobate when heated. The coating solution for forming the piezoelectric film preferably includes potassium and sodium such that the total content thereof is in a range of 0.9 mole or more and 1.2 mole or less when the total content of iron and niobium is 1 mole. The reason for increasing the total amount of potassium and sodium is that alkali metals, such as potassium and sodium, are dispersed in a greater amount during film deposition in comparison with heavy metals, such as iron and niobium. In addition, the content of iron and niobium in the coating solution is an amount in a range of 0.006 moles or more and 0.04 moles or less of Fe with respect to 1 mole of niobium.

The coating solution for forming the piezoelectric film is preferably a sol-gel solution including potassium, sodium, iron, and niobium. It is possible to prepare the sol-gel solution, for example, as follows. First, 2-ethylhexanoate, octanoic anhydride, sodium 2-ethylhexanoate (sodium source), and dimethyl succinate are added to a reaction container and refluxed. To the obtained reaction product, potassium 2-ethylhexanoate (potassium source), ethoxy niobium (niobium source), and iron 2-ethylhexanoate (iron source) are added in a ratio which generates iron-containing potassium sodium niobate upon being heated, and the obtained mixture is refluxed. Next, water and organic acid (for example, acetic acid) are added to the obtained reaction product and the mixture is refluxed again. After the refluxing, it is possible to prepare the sol-gel solution by further distilling under reduced pressure to remove by-products and unreacted residues and then diluting the obtained solution composition by adding 2-ethylhexanoate to adjust the concentration.

The coating solution for forming the piezoelectric film is coated on the electrodes of the substrate or the base layer formed on the surface of the electrode. The method for coating the coating solution is not particularly limited and it is possible to use a spin coating method, a dip coating method, an ink jet method, and the like.

### (Temporary Firing Step S02)

The temporary firing step S02 is a step of obtaining a temporarily fired film by temporarily firing the coated film obtained in the coating step S01. The heating temperature in the temporary firing step S02 is preferably equal to or higher than the temperature at which the solvent of the coating solution volatilizes and a temperature at which the iron-containing potassium sodium niobate does not crystallize. The reason why the temperature is a temperature at which the iron-containing potassium sodium niobate does not crystallize is that, when the iron-containing potassium sodium niobate is crystallized in the temporary firing step S02, it is difficult for the crystallization to proceed in the following main firing step S03. Specifically, the heating temperature is preferably in a range of 200°C or higher and 400°C or lower. The heating time varies depending on the film thickness of the coated film, the solvent content, and the like, but is preferably in a range of 30 seconds or more and 5 minutes or less. The heating atmosphere is not particularly limited; however, an atmospheric atmosphere or oxygen atmosphere is preferable. As a heating apparatus, it is possible to use a hot plate or an infrared rapid thermal annealing apparatus (RTA). Hot plates are preferable as the heating apparatus.

### (Main Firing Step S03)

The main firing step S03 is a step of heating the temporarily fired film obtained in the temporary firing step S02 to generate granular crystal particles containing iron-containing potassium sodium niobate and having a perovskite crystal structure, and firing the generated granular crystal particles to obtain a piezoelectric film. The heating temperature in this main firing step S03 may be equal to or higher than the crystallization start temperature of the iron-containing potassium sodium niobate. Specifically, the heating temperature is preferably in a range of 650°C or higher and 750°C or lower. In addition, in the main firing step S03, the temperature rise rate is preferably set in a range of 5°C/second or more and 200°C/second or less. By having the temperature rise rate in the range described above, the generation of the granular crystal particles and the firing of the granular crystal particles proceed smoothly, thus, the obtained piezoelectric film becomes fine and has a high density.

The heating time is different according to the thickness, size, and the like of the temporarily fired film, but is preferably in a range of 30 seconds or more and 5 minutes or less. The heating atmosphere is not particularly limited; however, an atmospheric atmosphere or oxygen atmosphere is preferable. As a heating apparatus, it is possible to use a hot plate or a rapid thermal annealing apparatus (RTA). The heating apparatus is preferably an RTA.

### (Piezoelectric Film Thickness Determining Step S04)

The piezoelectric film thickness determining step S04 is a step for measuring the film thickness of the piezoelectric film obtained in the main firing step S03 and determining whether or not the film thickness of the piezoelectric film is the desired film thickness. In a case where the film thickness of the piezoelectric film is thinner than the desired film thickness (the case of NO in Fig. 3), the coating step S01, the temporary firing step S02, and the main firing step S03 are performed again to laminate the piezoelectric film on the surface of the piezoelectric film to increase the film thickness of the entire piezoelectric film. In addition, in a case where the film thickness of the piezoelectric film is thicker than the desired film thickness, the coating amount of the coating solution in the coating step S01 is adjusted. In a case where the film thickness of the piezoelectric film is the desired film thickness (the case of YES in Fig. 3), the manufacturing of the piezoelectric film is completed. It is possible to measure the film thickness of the piezoelectric film using, for example, a spectral interference film thickness measurement apparatus.

It is possible to produce the piezoelectric element by forming an upper electrode on the surface of the piezoelectric film obtained as described above.

The piezoelectric film 10 of the present embodiment, which is configured as described above, contains iron-containing potassium sodium niobate as represented in General Formula (1) and is formed of granular crystal particles having an average aspect ratio of 3 or less, thus, it is possible to suppress the generation of leakage current even when the film thickness is reduced.

In addition, in the piezoelectric film 10 of the present embodiment, the electron conductivity between the granular crystal particles is reliably improved by the average particle diameter of the granular crystal particles being in a range of 10 nm or more and 300 nm or less. For this reason, it is possible to more reliably suppress the leakage current of the piezoelectric film 10 even when the film thickness is reduced.

In the piezoelectric element 1 of the present embodiment, since the piezoelectric layer 11 includes the piezoelectric film 10 described above, it is possible to suppress the generation of leakage current even when the thickness is reduced and the size is made smaller.

Although embodiments of the present invention were described above, the present invention is not limited thereto and is able to be changed as appropriate in a range not departing from the technical concept of the invention.

### EXAMPLES

Next, explanation will be given of the effects of the present invention by means of Examples.

### [Invention Example 1]

### (1) Production of Substrate

A silicon substrate (size: 20 mm length x 20 mm width x 0.5 mm thickness) was prepared as a heat-resistant substrate. A thermal oxide film with a thickness of 500 nm was formed on the surface of the prepared silicon substrate by thermal oxidation. Next, an aluminum oxide film (Al₂O₃ film) with a thickness of 80 nm was formed on the surface of this thermal oxide film by the CSD method. Next, a titanium film with a thickness of 20 nm was formed on the surface of the aluminum oxide film by the sputtering method and then the titanium film was oxidized to form a titanium oxide film (TiOₓ film) by firing at a temperature of 700°C in an oxygen atmosphere for 1 minute in a rapid heating treatment (RTA). Next, a (111) oriented Pt lower electrode with a thickness of 100 nm was formed on the surface of the titanium oxide film by the sputtering method. Furthermore, a 15 nm thick lanthanum nickel oxide film (LNO film) was formed on the surface of the Pt lower electrode by the CSD method. In this manner, a substrate in which a thermal oxide film, an aluminum oxide film, a titanium oxide film, a Pt lower electrode, and a lanthanum nickel oxide film were laminated on the surface of a silicon substrate was produced.

### (2) Preparation of Coating Solution for Forming Piezoelectric Film

After 2-ethylhexanoate, octanoic anhydride, sodium 2-ethylhexanoate, and dimethyl succinate were added to a flask in a molar ratio of 5:3:1:4, refluxing was performed for 30 minutes using an oil bath at 150°C. After refluxing, potassium 2-ethylhexanoate, ethoxy niobium, and iron 2-ethylhexanoate were added to produce a mixture including potassium, sodium, iron, and niobium in a molar ratio of 0.5:0.5:0.02:0.98 (=K:Na:Fe:Nb), then refluxing was performed for 30 minutes using an oil bath at 150°C. After the refluxing, water and acetic acid were added thereto and the refluxing was again performed for 30 minutes at 150°C. After the refluxing, the by-products and unreacted residues were removed by distillation while reducing the pressure to 0.015 MPa using an aspirator. To the obtained solution composition, 2-ethylhexanoate was added and diluted such that the amount of iron-containing potassium sodium niobate generated by heating 100 parts by mass of the solution composition was 10 parts by mass. The obtained diluted solution was filtered by a filter to remove residue and a coating solution for forming a piezoelectric film was prepared.

### (3) Production of Substrate with Piezoelectric Film

The coating solution for forming the piezoelectric film prepared in (2) described above was added dropwise onto the surface of the LNO film of the substrate produced in (1) described above and spin-coated for 20 seconds at a rotational speed of 3000 rpm (coating step S01). Next, the obtained substrate with the coated film was fired at 250°C for 3 minutes using a hot plate (temporary firing step S02). Then, the temperature was raised to 700°C in an oxygen atmosphere at a temperature rise rate of 50°C/second using the RTA, and fired at 700°C for 1 minute (main firing step S03). These steps were repeated 20 times to produce a substrate with a piezoelectric film having a piezoelectric film with a film thickness of 1 µm.

### (4) Production of Piezoelectric Element

On the surface of the piezoelectric film of the substrate with a piezoelectric film obtained in (3) described above, square-shaped Pt upper electrode pieces having a length of 0.25 mm per side and a thickness of 100 nm were formed by the sputtering method in a grid form of 6 squares in the vertical direction x 6 squares in the horizontal direction (36 squares in total) at intervals of 2 mm to produce a piezoelectric element.

### [Evaluation]

For the substrate with a piezoelectric film obtained in (3) described above, the composition of the piezoelectric film was determined by measuring the amount of metal elements in the piezoelectric film using X-ray fluorescence (XRF analysis) and calculating the molar ratios of the metal elements. The results are shown in Table 1 below. The molar ratios of the metal elements listed in Table 1 are values based on the composition of (KNa)(FeNb)O₃, which forms perovskite crystals.

The cross-section of the piezoelectric film of the substrate with piezoelectric film obtained in (3) described above was observed using an SEM (SU8000, manufactured by Hitachi High-Tech Corporation). Fig. 4 shows an SEM photograph of a cross-section of a piezoelectric film. Furthermore, using the SEM photograph, the long and short diameters of 200 crystal particles were measured and the average aspect ratio (average of long diameter/short diameter) and average particle diameter (average of the long diameters) were calculated. The results are shown in Table 1 below.

For the piezoelectric element obtained in (4) described above, the lower Pt electrode and the upper Pt electrode piece were connected via a power supply device (Keithley 236) and the current value when a voltage was applied between the lower Pt electrode and the upper Pt electrode piece was measured as the leakage current value. The leakage current value was measured by sweeping the voltage from 0 to 600 kV/cm in steps of 5 kV/cm in LINEAR, under conditions of a delay time (delay time) of 0.1 seconds and 32 times of integration. Leakage current values were measured for each upper Pt electrode formed in the grid form. The average of the leakage current values was calculated when a voltage of 100 kV/cm was applied between each upper Pt electrode and the lower Pt electrode and values of 1×10⁻⁵/cm² or less were designated as A and values exceeding 1×10⁻⁵/cm² were designated as B. The results are shown in Table 1 below.

### [Invention Example 2]

A substrate with a piezoelectric film and a piezoelectric element were produced in the same manner as in Invention Example 1, except that in the preparation of the coating solution for forming the piezoelectric film of (2) in Invention Example 1, the raw materials were blended such that the molar ratio of potassium, sodium, iron, and niobium in the mixture was 0.5:0.5:0.01:0.99 (=K:Na:Fe:Nb). The composition and particle size of the obtained piezoelectric film plate and the evaluation results of the leakage current value of the piezoelectric oscillator are shown in Table 1 below.

### [Invention Example 3]

A substrate with a piezoelectric film and a piezoelectric element were produced in the same manner as in Invention Example 1, except that in the preparation of the coating solution for forming the piezoelectric film of (2) in Invention Example 1, the raw materials were blended such that the molar ratio of potassium, sodium, iron, and niobium in the mixture was 0.5:0.5:0.03:0.97 (=K:Na:Fe:Nb). The composition and particle size of the obtained substrate with a piezoelectric film and the evaluation results of the leakage current value of the piezoelectric oscillator are shown in Table 1 below.

### [Invention Example 4]

A substrate with a piezoelectric film and a piezoelectric element were produced in the same manner as in Invention Example 1, except that in the preparation of the coating solution for forming the piezoelectric film of (2) in Invention Example 1, the raw materials were blended such that the molar ratio of potassium, sodium, iron, and niobium in the mixture was 0.5:0.5:0.035:0.965 (=K:Na:Fe:Nb). The composition and particle size of the obtained piezoelectric film and the evaluation results of the leakage current value of the piezoelectric oscillator are shown in Table 1 below.

### [Comparative Example 1]

A substrate with a piezoelectric film and a piezoelectric element were produced in the same manner as in Invention Example 1, except that in the preparation of the coating solution for forming the piezoelectric film of (2) in Invention Example 1, without adding 2-ethylhexanoate, the raw materials were blended such that the molar ratio of potassium, sodium, and niobium in the mixture was 0.5:0.5:1 (=K:Na:Nb). The composition and particle size of the obtained substrate with a piezoelectric film and the evaluation results of the leakage current value of the piezoelectric oscillator are shown in Table 1 below.

### [Comparative Example 2]

A substrate with a piezoelectric film and a piezoelectric element were produced in the same manner as in Invention Example 1, except that in the preparation of the coating solution for forming the piezoelectric film of (2) in Invention Example 1, the raw materials were blended such that the molar ratio of potassium, sodium, iron, and niobium in the mixture was 0.5:0.5:0.005:0.995 (=K:Na:Fe:Nb). The composition and particle size of the obtained piezoelectric film and the evaluation results of the leakage current value of the piezoelectric oscillator are shown in Table 1 below.

### [Comparative Example 3]

A substrate with a piezoelectric film and a piezoelectric element were produced in the same manner as in Invention Example 1, except that in the preparation of the coating solution for forming the piezoelectric film of (2) in Invention Example 1, the raw materials were blended such that the molar ratio of potassium, sodium, iron, and niobium in the mixture was 0.5:0.5:0.05:0.95 (=K:Na:Fe:Nb). The composition and particle size of the obtained piezoelectric film and the evaluation results of the leakage current value of the piezoelectric oscillator are shown in Table 1 below.

### [Comparative Example 4]

A substrate with a piezoelectric film and a piezoelectric element were produced in the same manner as in Invention Example 1, except that in the preparation of the coating solution for forming the piezoelectric film of (2) in Invention Example 1, manganese 2-ethylhexanoate was used instead of iron 2-ethylhexanoate, and the raw materials were blended such that the molar ratio of potassium, sodium, manganese, and niobium in the mixture was 0.5:0.5:0.01:0.99 (=K:Na:Mn:Nb). The composition and particle size of the obtained piezoelectric film and the evaluation results of the leakage current value of the piezoelectric oscillator are shown in Table 1 below.

**[Table 1]**

| | Characteristics of piezoelectric film | | | | | | Evaluation |
|---|---|---|---|---|---|---|---|
| | Composition (molar ratio) | | | | Particle size | | Leakage current |
| | K content | Na content | Fe content | Nb content | Average aspect ratio | Average particle diameter (nm) | |
| Invention example 1 | 0.5 | 0.5 | 0.02 | 0.98 | 1 | 40.0 | A |
| Invention example 2 | 0.5 | 0.5 | 0.01 | 0.99 | 1.5 | 50.0 | A |
| Invention example 3 | 0.5 | 0.5 | 0.03 | 0.97 | 1.1 | 37.0 | A |
| Invention example 4 | 0.5 | 0.5 | 0.035 | 0.965 | 1.1 | 38.0 | A |
| Comparative example 1 | 0.5 | 0.5 | 0 | 1 | 7.0 | 150.0 | B |
| Comparative example 2 | 0.5 | 0.5 | 0.005 | 0.995 | 6.0 | 170.0 | B |
| Comparative example 3 | 0.5 | 0.5 | 0.05 | 0.95 | 1 | 39.0 | B |
| Comparative example 4 | 0.5 | 0.5 | Mn content 0.01 | 0.99 | 7.0 | 150.0 | B |

The piezoelectric films of Invention Examples 1 to 4 using iron-containing potassium sodium niobate including iron in the range of the present invention with respect to niobium all had an average aspect ratio of the crystal particles of 3 or less and a leakage current value of 1 × 10⁻⁵/cm² or less. In contrast, the piezoelectric film of Comparative Example 1, in which potassium sodium niobate not including Fe was used, had a large average aspect ratio and a leakage current value exceeding 1×10⁻⁵/cm². In addition, the piezoelectric film of Comparative Example 2, in which iron-containing potassium sodium niobate including iron in an amount less than the range of the present invention was used, had a lower average aspect ratio than Comparative Example 1, but the leakage current exceeded 1×10⁻⁵/cm². On the other hand, the piezoelectric film of Comparative Example 3, in which iron-containing potassium sodium niobate including iron in an amount higher than the range of the present invention was used, had an average aspect ratio of 1, but the leakage current value exceeded 1×10⁻⁵/cm². This is considered to be due to the excessive presence of iron at the grain boundaries, which made it difficult to suppress the generation of leakage current. Furthermore, the piezoelectric film of Comparative Example 4, in which manganese-containing potassium sodium niobate including 0.01 mole of manganese with respect to 1 mole niobium was used, had an average aspect ratio of 7.0, which was equivalent to the piezoelectric film of Comparative Example 1, and the leakage current value exceeded 1×10⁻⁵/cm².

From these results, it was confirmed that Fe has an effect of suppressing the crystal particles from growing into a columnar shape and that the leakage current value is reduced when the crystal particles are granular with a low aspect ratio.

### INDUSTRIAL APPLICABILITY

In the KNN-based piezoelectric films and piezoelectric elements of the present embodiment, leakage current is not easily generated even when the film thickness is reduced. For this reason, the KNN-based piezoelectric films and piezoelectric elements of the present embodiment are advantageously applicable to various piezoelectric devices, such as vibration-generating elements, sensors, actuators, ink jet heads, and autofocusing devices.

### REFERENCE SIGNS LIST

- 1:: Piezoelectric element
- 10:: Piezoelectric film
- 11:: Piezoelectric layer
- 20:: Electrode layer
- 21:: Upper electrode
- 22:: Lower electrode
- 30:: Granular crystal particles
- S₁, S₂:: Straight line

## Claims

1. A piezoelectric film comprising:
iron-containing potassium sodium niobate represented by General Formula (1); and
granular crystal particles having an average aspect ratio of 3 or less,
(KₓNa₁₋ₓ)ₐ(Fe_{y}Nb_{z})O₃ ... (1)
in Formula (1), x represents a number satisfying 0 < x < 1, a represents a number satisfying 0.90 < a ≤ 1, and y and z represent numbers satisfying y + z = 1 and 0.006 ≤ y/z ≤ 0.04.

2. The piezoelectric film according to claim 1, wherein the granular crystal particles have an average particle diameter in a range of 10 nm or more and 300 nm or less.

3. A piezoelectric element comprising:
a piezoelectric layer; and
an electrode layer arranged on a surface of the piezoelectric layer,
wherein the piezoelectric layer includes the piezoelectric film according to claim 1 or 2.
